# EUROPEAN PATENT APPLICATION

(11) **EP 1 650 864 A1**
(43) Date of publication of application: **26.04.2006**
(21) Application number: 04748085.0
(22) Date of filing: 23.07.2004
(51) Int. Cl.: H03F 3/20, H04B 1/04, H03F 3/189

(54) **AMPLIFICATION APPARATUS**

(30) Priority: 25.07.2003 JP 2003280256; 29.09.2003 JP 2003336801; 24.02.2004 JP 2004048341
(71) Applicant: MATSUSHITA ELECTRIC INDUSTRIAL CO., LTD., Kadoma-shi, Osaka 571-8501 (JP)
(72) Inventor: IKEDO, Taichi, Yokohama-shi, Kanagawa 232-0075 (JP); ARAYASHIKI, Mamoru, Yokohama-shi, Kanagawa 234-0052 (JP)
(74) Representative: Grünecker, Kinkeldey, Stockmair & Schwanhäusser Anwaltssozietät
(86) International application number: PCT/JP2004/010877
(87) International publication number: WO 2005/011109

(57) **Abstract**

A power supply voltage control section 200 is provided with an adder 11 that adds together a baseband amplitude modulation signal 101 and a negative feedback signal, an integrator 12 that integrates the output of adder 11, a quantizer 13 that quantizes the output of integrator 12, and a low pass filter 14 that eliminates quantization noise from the output of quantizer 13, together with a compensator 15 that has an inverse characteristic of low pass filter 14 or a characteristic approximating thereto and performs compensation of the feedback amount of the negative feedback signal.

## Description

### Technical Field

The present invention relates to an amplification apparatus used in a radio transmitter.

### Background Art

In the design of conventional linear transmission modulators, there is generally a trade-off between efficiency and linearity. Recently, however, a technology has been proposed that enables compatibility between efficiency and linearity to be achieved in a linear transmission modulator by using polar modulation.

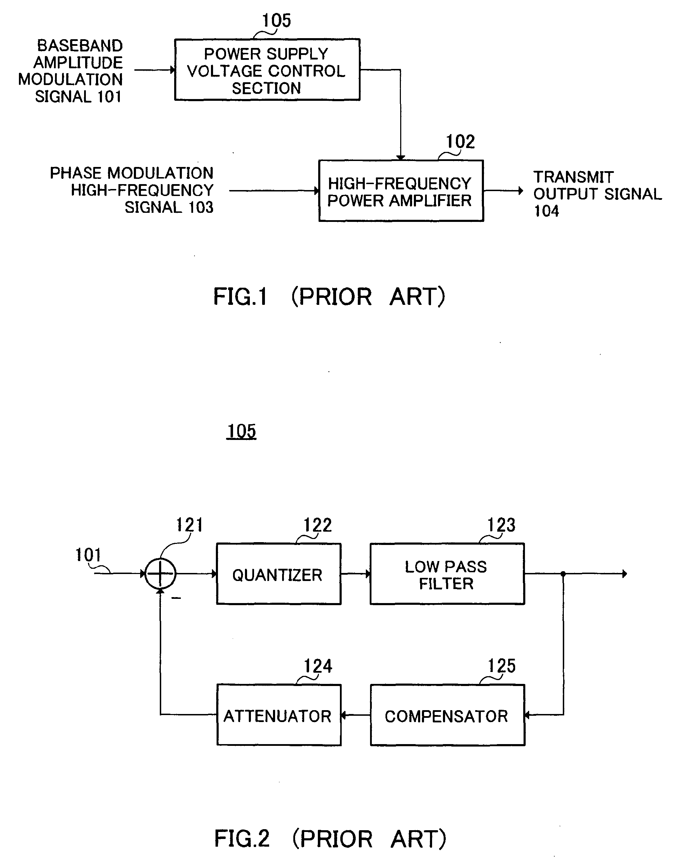

FIG.1 is a block diagram showing a sample configuration of a linear transmission modulator that uses polar modulation. A baseband amplitude modulation signal (for example, √I²+Q²) 101 separated from a baseband modulation signal by an amplitude/phase separation section (not shown) is input to a power supply voltage control section 105 that forms a control signal for controlling the power supply voltage of a high-frequency power amplifier 102. The control signal formed by power supply voltage control section 105 is sent to high-frequency power amplifier 102.

A phase modulation high-frequency signal 103 is input to high-frequency power amplifier 102. Phase modulation high-frequency signal 103 is obtained by first having a phase component (for example, the angle formed by a modulated symbol and the I-axis) of the baseband modulation signal separated by the amplitude/phase separation section (not shown), and having a carrier frequency signal modulated by this phase component.

High-frequency power amplifier 102 is a nonlinear amplifier, and the power supply voltage value is set in accordance with a control signal from power supply voltage control section 105. By this means, a transmit output signal 104 signal resulting from multiplying together the power supply voltage value and phase modulation high-frequency signal 103 and amplifying this signal by the gain of high-frequency power amplifier 102 is output from high-frequency power amplifier 102. Transmit output signal 104 is transmitted from an antenna (not shown).

When polar modulation is used in this way, phase modulation high-frequency signal 103 input to high-frequency power amplifier 102 can be made a fixed envelope signal that has no amplitude modulation component, enabling a high-efficiency nonlinear amplifier to be used as high-frequency power amplifier 102.

In order to maximize efficiency, power supply voltage control section 105 is often implemented by using a switching mode power supply that had a class D amplifier as its output stage. A normal switching mode power supply is generally implemented using pulse width modulation, and the output of such a power supply is a rectangular wave in which the Hi (high level) / Lo (low level) ratio represents amplitude modulation signal 101.

However, when pulse width modulation is performed in power supply voltage control section 105, inter modulation distortion occurs in the transmit output signal. A technique for solving this problem is to use a delta modulation circuit configuration comprising an adder 121, quantizer 122, lowpass filter 123, compensator 125, and attenuator 124 for power supply voltage control section 105, perform delta modulation of amplitude modulation signal 101, and supply the modulated signal to high-frequency power amplifier 102 (see, for example, Un examined Japanese Patent Publication No. HEI 10-256843) . By this means, delta modulation of the switching mode power supply is performed and distortion appearing in transmit output signal 104 can be improved by a delta modulation negative feedback loop.

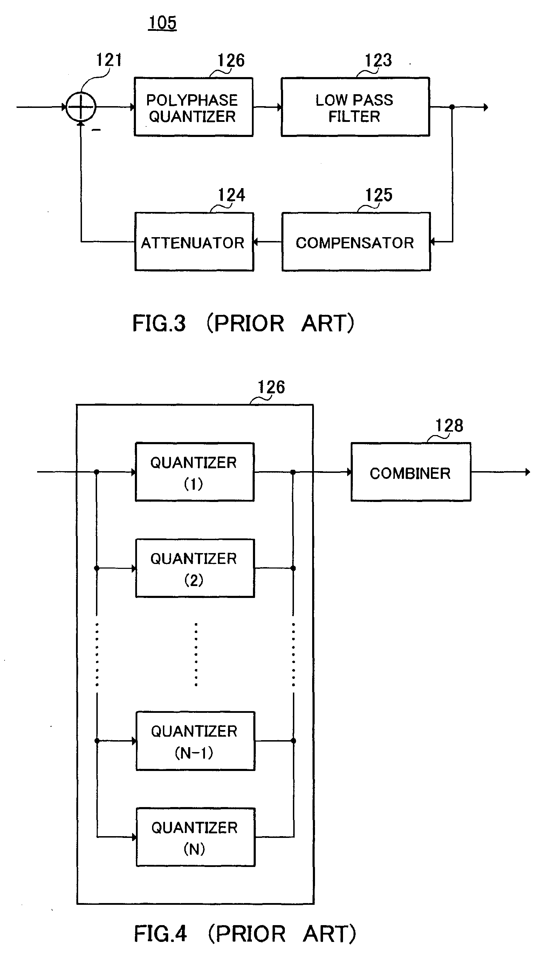

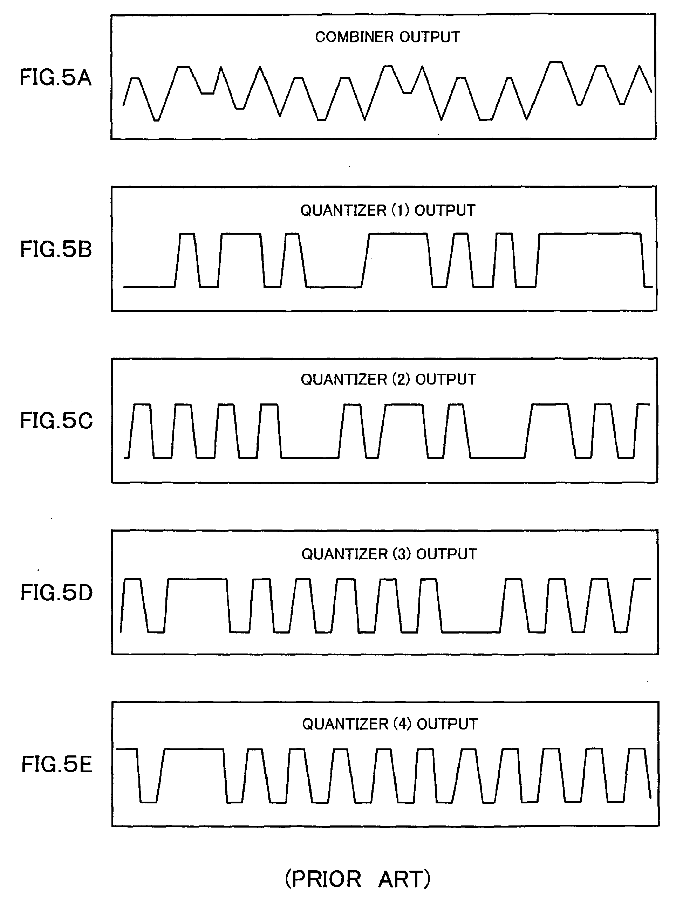

Furthermore, it has been proposed that a delta modulation configuration using a polyphase quantizer 126 should be applied to power supply voltage control section 105 as shown in FIG.3 (see, for example, Unexamined Japanese Patent Publication No.2001-156554).As shown in FIG. 4, polyphase quantizer 126 is composed of N quantizers (1 through N) operating at a (1/N) sampling rate with respective (360/N) degree phase displacement, and quantizer outputs are combined by a combiner 128 and output in (N+1) value form. FIG. 5A through FIG. 5E show polyphase quantizer 126 waveforms (when N = 4).The polyphase quantizer 126 waveform has the form shown in FIG.5A, comprising a composite wave of the outputs of a plurality of quantizers as shown in FIG. 5B through FIG.5E. Use of this kind of polyphase quantizer 126 enables the speed of the quantizers to be reduced, allowing required quantizer conditions to be relaxed, and making possible wider-band amplitude modulation by power supply voltage control section 105.

However, as a DC (direct current) component cannot be transmitted with delta modulation, a fixed voltage (DC component) cannot be output from power supply voltage control section 105. That is to say, when delta modulation is used, it is difficult to provide a fixed voltage as the power supply of high-frequency power amplifier 102. Consequently, when implementation of a transmit modulator capable of handling a plurality of modulation methods is attempted, for example, the power supply voltage control section cannot be shared with a modulation method in which there is no amplitude modulation component (such as the GSM method). Also, if amplitude modulation must be performed in a stage prior to high-frequency power amplifier 102, high-frequency power amplifier 102 must be switched from switching operation to linear operation, and it is difficult to provide a fixed voltage as the high-frequency power amplifier 102 power supply at that time. Thus, it has also been proposed that power supply voltage control section 105 should have a delta sigma modulator configuration comprising power supply voltage control section 105, adders 131 and 132, an integrator 133, quantizer 134, low pass filter 135, attenuators 136 and 137, and a phase compensator 138, as shown in FIG.6 (see, for example, Unexamined Japanese Patent Publication No.2000-307359). According to this configuration, amplitude modulation signal 101 undergoes delta sigma modulation and is supplied to high-frequency power amplifier 102, enabling a DC component to be transmitted using delta sigma modulation instead of pulse width modulation.

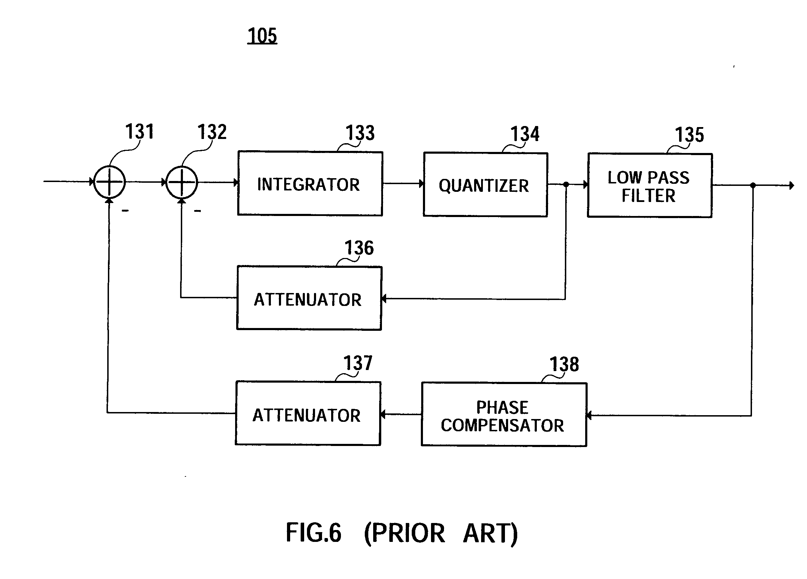

The example in FIG.6 has a dual-loop configuration whereby, together with the negative feedback loop of the delta sigma modulation section, the output of low pass filter 135 that eliminates quantization noise by delta sigma modulation is fed back to the delta sigma modulation section after passing through phase compensator 138 (having a characteristic that cancels out the phase characteristic of the low pass filter). This improves distortion created by low pass filter 135.

However, a drawback of power supply voltage control section 105 using delta sigma modulation as described above is that the dual-loop configuration makes it necessary to distribute the loop gain of each loop appropriately, and instability due to feedback is greater than when there is a single loop.Disclosure of Invention

It is an object of the present invention to provide an amplification apparatus that enables high-frequency power amplification to be performed stably and also enables high-frequency power amplification output distortion to be reduced.

This object is achieved by providing the power supply voltage control section of a high-frequency power amplifier with an adder that adds together a baseband amplitude modulation signal and negative feedback signal, an integrator that integrates adder output, a quantizer that quantizes integrator output, and a low pass filter that eliminates quantization noise from quantizer output, together with a compensator that has an inverse characteristic of the low pass filter or a characteristic approximating thereto and performs compensation of the feedback amount of the negative feedback signal.

### Brief Description of Drawings

FIG.1 is a block diagram showing the configuration of a conventional amplification apparatus;
FIG.2 is a block diagram showing a configuration of a conventional power supply voltage control section;
FIG.3 is a block diagram showing another configuration of a conventional power supply voltage control section;
FIG.4 is a block diagram showing the configuration of a polyphase quantizer;
FIG. 5A is a drawing showing the output waveform of a combiner provided in a stage following a polyphase quantizer;
FIG.5B through FIG. 5E are drawings showing the output waveforms of quantizers making up a polyphase quantizer;
FIG.6 is a block diagram showing the configuration of the power supply voltage control section of a conventional delta sigma modulator configuration;
FIG.7 is a block diagram showing the configuration of a linear transmission modulator according to a first embodiment;
FIG.8 is a block diagram showing the configuration of a power supply voltage control section according to a second embodiment;
FIG.9 is a block diagram showing the configuration of a power supply voltage control section according to a third embodiment;
FIG. 10 is a block diagram showing the configuration of a power supply voltage control section according to a fourth embodiment;
FIG. 11 is a block diagram showing the configuration of a power supply voltage control section according to a fifth embodiment;
FIG.12 is a block diagram showing the configuration of an amplification apparatus according to a sixth embodiment;
FIG.13 is a block diagram showing the configuration of an amplification apparatus according to a seventh embodiment;
FIG.14 is a block diagram showing the configuration of a power supply voltage control section according to an eighth embodiment; and
FIG. 15 is a block diagram showing the configuration of a variable-output quantizer according to the eighth embodiment.

### Best Mode for Carrying out the Invention

With reference now to the accompanying drawings, embodiments of the present invention will be explained in detail below.

In the following embodiments, sample configurations are shown in which an amplification apparatus of the present invention is applied to a high-efficiency type linear transmission modulator in a transmitting apparatus. The linear transmission modulator in these embodiments is installed in a radio that performs radio transmission by means of polar modulation. In actuality, an amplification apparatus of the present invention is used, for example, in a mobile terminal apparatus of a mobile communication system or a base station apparatus that performs communication with this mobile terminal apparatus.

### (First Embodiment)

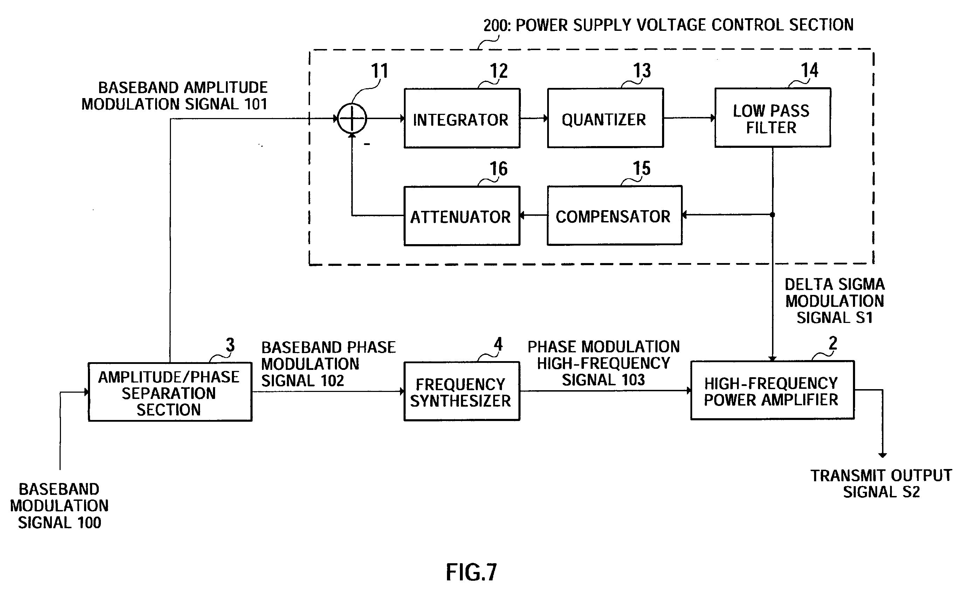

FIG.7 is a block diagram showing the configuration of a linear transmission modulator according to a first embodiment of the present invention.

A linear transmission modulator of this embodiment has an amplitude/phase separation section 3 that separates a baseband modulation signal 100 into a baseband amplitude modulation signal 101 comprising an amplitude modulation component (for example, √I²+Q²) and a baseband phase modulation signal 102 comprising a phase modulation component (for example, the angle formed by a modulated symbol and the I-axis), a frequency synthesizer 4 that performs phase modulation of a high-frequency signal by means of baseband phase modulation signal 102 and converts this signal to a phase modulation high-frequency signal 103, a nonlinear high-frequency power amplifier 2 that amplifies frequency synthesizer 4 output phase modulation high-frequency signal 103, and a power supply voltage control section 200 that forms a control signal (in the case of this embodiment, a delta sigma modulation signal) S1 for controlling the power supply voltage of high-frequency power amplifier 2 based on baseband amplitude modulation signal 101.

Power supply voltage control section 200 has a delta sigma modulator configuration, obtains delta sigma modulation signal S1 by delta sigma modulation of baseband amplitude modulation signal 101, and outputs this as the high-frequency power amplifier 2 power supply voltage control signal. This power supply voltage control section 200 comprises an adder 11, an integrator 12 that integrates the output of adder 11, a quantizer 13 that quantizes the output of integrator 12 in accordance with a predetermined threshold value, a low pass filter 14 that eliminates quantization noise contained in quantizer 13 output, a compensator 15 that carries out feedback amount compensation when low pass filter 14 output feedback is performed, and an attenuator 16 that adjusts compensator 15 output to the level of baseband amplitude modulation signal 101 and outputs the resulting signal to adder 11. The elements of power supply voltage control section 200 may be implemented by means of analog circuitry or by means of digital circuitry.

The operation of a linear transmission modulator according to the first embodiment will now be explained. Baseband modulation signal 100 is separated into baseband amplitude modulation signal 101 and baseband phase modulation signal 102 by amplitude/phase separation section 3. Then baseband amplitude modulation signal 101 is input to power supply voltage control section 200 and baseband phase modulation signal 102 is input to frequency synthesizer 4.

Adder 11 in power supply voltage control section 200 adds together input baseband amplitude modulation signal 101 and the output of attenuator 16 located in the feedback loop (actually, subtraction is performed as this is a negative feedback loop). Integrator 12 integrates the output of adder 11, and quantizer 13 quantizes the output of integrator 12 in accordance with a predetermined threshold value. Low pass filter 14 eliminates quantization noise contained in the output of quantizer 13. The output of low pass filter 14 is sent to high-frequency power amplifier 2 as delta sigma modulation signal S1, and is also sent to compensator 15 located in the negative feedback loop. Compensator 15 generates a compensation value for feeding back the output of low pass filter 14, and sends this to attenuator 16. Attenuator 16 attenuates the compensation value to a predetermined level and adjusts it to the level of baseband amplitude modulation signal 101 before outputting it to adder 11 as a negative feedback signal. At this time, power supply voltage control section 200 operates as a class D amplifier.

Meanwhile, frequency synthesizer 4 performs phase modulation of a high-frequency signal with input baseband phase modulation signal 102 and performs conversion to phase modulation high-frequency signal 103, and outputs this signal to high-frequency power amplifier 2. High-frequency power amplifier 2 sets a power supply voltage in accordance with delta sigma modulation signal S1, which is the power supply voltage control signal, and amplifies phase modulation high-frequency signal 103 with the set power supply voltage. In other words, this is equivalent to combining, by multiplication, phase modulation high-frequency signal 103 and delta sigma modulation signal S1 provided from power supply voltage control section 200.

In power supply voltage control section 200 of this embodiment, operation is implemented even though low pass filter 14 is inserted in the delta sigma modulation negative feedback loop by having the inverse characteristic of low pass filter 14 provided by compensator 15. By this means, the need for dual feedback loops as in the conventional case is eliminated and power supply voltage control section 200 with a delta sigma modulator configuration can be configured with a single feedback loop, and furthermore distortion created by low pass filter 14 can be improved by this delta sigma modulation negative feedback loop. By using a single-loop configuration for the feedback circuit, the stability of delta sigma modulation can be improved, and consequently transmit output signal S2 output from high-frequencypower amplifier 2 canbe stabilized. Also, by controlling the power supply voltage of high-frequency power amplifier 2 by delta sigma modulation of baseband amplitude modulation signal 101 using power supply voltage control section 200 with a delta sigma modulator configuration, distortion of transmit output signal S2 output from high-frequency power amplifier 2 can be improved.

The characteristic of compensator 15 need not necessarily be completely matched to the inverse characteristic of low pass filter 14, but need only approximate the inverse characteristic. A low pass filter is often configured as an LC filter, and in terms of order is a second-order filter, but inverse characteristic approximation is sufficient as a first-order characteristic. Using this kind of configuration enables distortion created by low pass filter 14 to be improved by a delta sigma modulation negative feedback loop.

### (Second Embodiment)

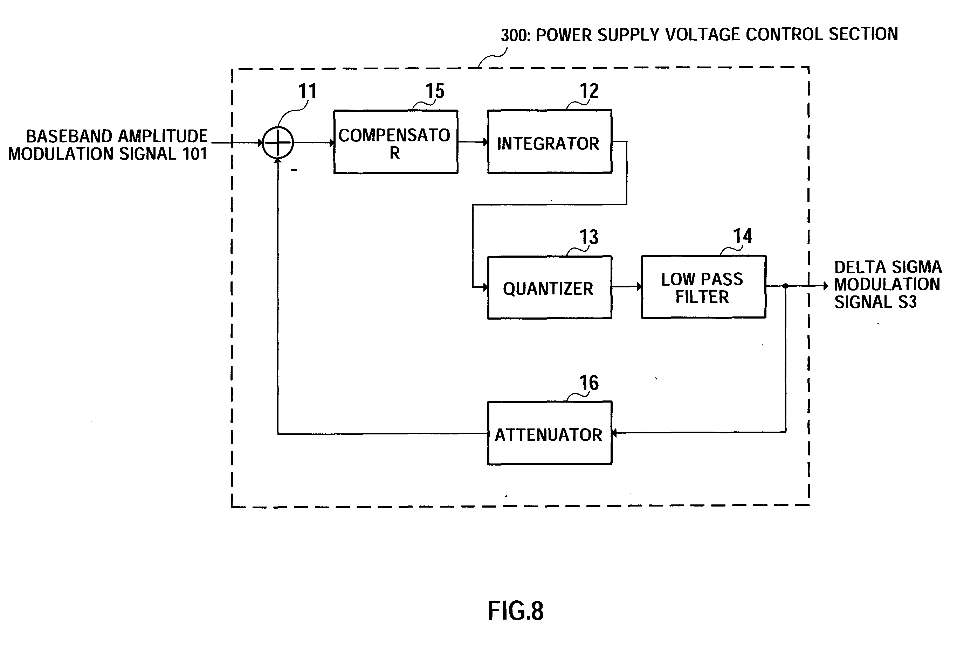

FIG.8, in which parts corresponding to those in FIG. 7 are assigned the same codes as in FIG.7, shows the configuration of a power supply voltage control section according to a second embodiment of the present invention. Power supply voltage control section 300 of this embodiment basically has a delta sigma modulator configuration as in the first embodiment, but its configuration differs partially from that of the first embodiment.

In power supply voltage control section 300, compensator 15 is located between adder 11 and integrator 12 rather than in the feedback loop, the output of adder 11 undergoes compensation by compensator 15, and the output of compensator 15 is integrated by integrator 12. The rest of the configuration is the same as in the first embodiment.

Generally, as the circuit scale of a negative feedback loop increases, the path by which a signal is fed back becomes longer, and the circuit may become unstable due to the occurrence of oscillation and so forth. Thus, in this embodiment, compensator 15, which was included in the negative feedback loop in the first embodiment, is located between adder 11 and integrator 12. This enables the circuit scale of the negative feedback loop to be decreased. Although the location of compensator 15 is different, loop gain is virtually the same in both the first and second embodiments.

Also, compensator 15, integrator 12, and quantizer 13 can be more easily integrated than low pass filter 14 and attenuator 16, and locating compensator 15 in the main loop as in this embodiment does not increase the overall circuit scale.

According to the second embodiment, only attenuator 16 is located in the negative feedback loop, enabling the feedback loop circuit scale to be reduced.

### (Third Embodiment)

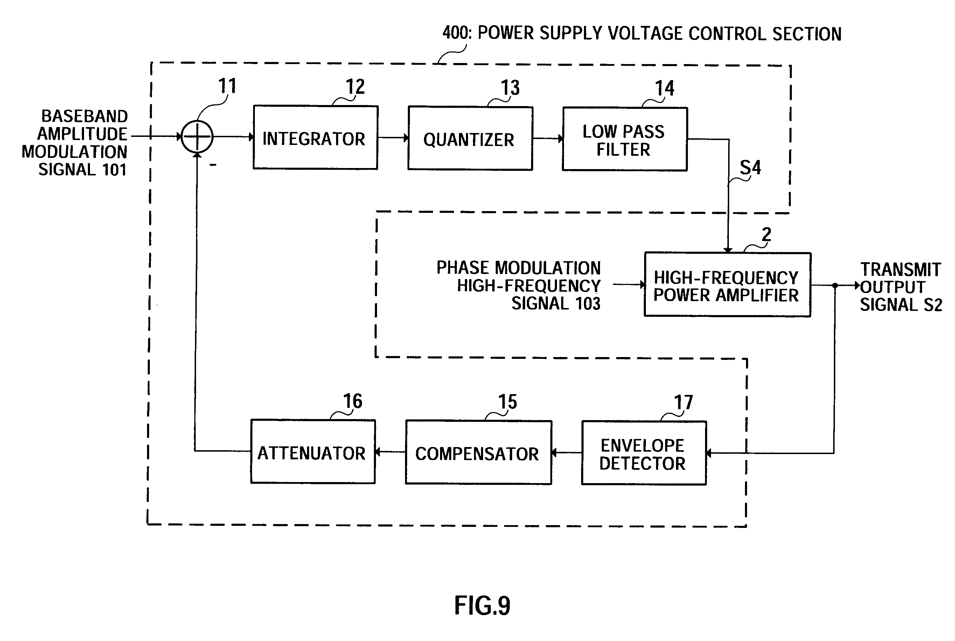

FIG. 9, in which parts corresponding to those in FIG. 7 are assigned the same codes as in FIG.7, shows the configuration of a power supply voltage control section according to a third embodiment of the present invention. Power supply voltage control section 400 of this embodiment basically has a delta sigma modulator configuration as in the first embodiment, but its configuration differs partially from that of the first embodiment.

In power supply voltage control section 400 an envelope detector 17 is provided, and instead of the output of low pass filter 14 being fed back as shown in the first embodiment in FIG.7, a baseband amplitude modulation signal is extracted by envelope detector 17 from transmit output signal S2 output from high-frequency power amplifier 2, and this is fed back to adder 11 via compensator 15 and attenuator 16. The rest of the configuration is the same as in the first embodiment.

According to the third embodiment, by means of a delta sigma modulation negative feedback loop whereby feedback is performed from the output of high-frequency power amplifier 2 to input-stage adder 11, it is possible to improve distortion created by high-frequency power amplifier 2 in addition to distortion created by low pass filter 14. Other effects are the same as the effects illustrated in the first embodiment.

### (Fourth Embodiment)

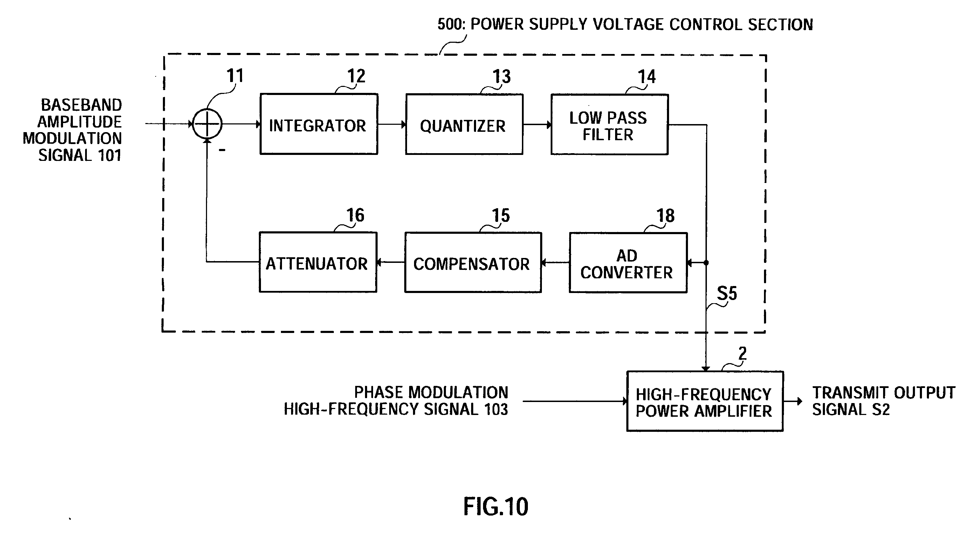

FIG.10, in which parts corresponding to those in FIG.7 are assigned the same codes as in FIG.7, shows the configuration of a power supply voltage control section according to a fourth embodiment of the present invention. Power supply voltage control section 500 of this embodiment basically has a delta sigma modulator configuration as in the first embodiment, but its configuration differs partially from that of the first embodiment.

In power supply voltage control section 500 an AD converter 18 is provided, and the output of low pass filter 14 undergoes AD (analog-digital) conversion by AD converter 18 before being fed back to adder 11 via compensator 15 and attenuator 16. Thus, in this embodiment, adder 11, integrator 12, quantizer 13, compensator 15, and attenuator 16 of power supply voltage control section 500 are implemented by means of digital circuitry. Otherwise, this embodiment is the same as the first embodiment.

According to the fourth embodiment, it is possible for a baseband modulation signal to be processed digitally, and power supply voltage control section 500 can be given constant characteristics that reduce susceptibility to the effects of element variation and so forth. By this means, it is possible to provide uniform high-frequency power amplifier 2 operating characteristics and obtain a transmit output signal S2 conforming to specifications.

In the above-described embodiment, AD converter 18 is located on the output side of low pass filter 14, but power supply voltage control section 400 can be similarly digitalized, and the same kind of effect can be obtained, by locating AD converter 18 on the output side of envelope detector 17 of the third embodiment shown in FIG.9.

### (Fifth Embodiment)

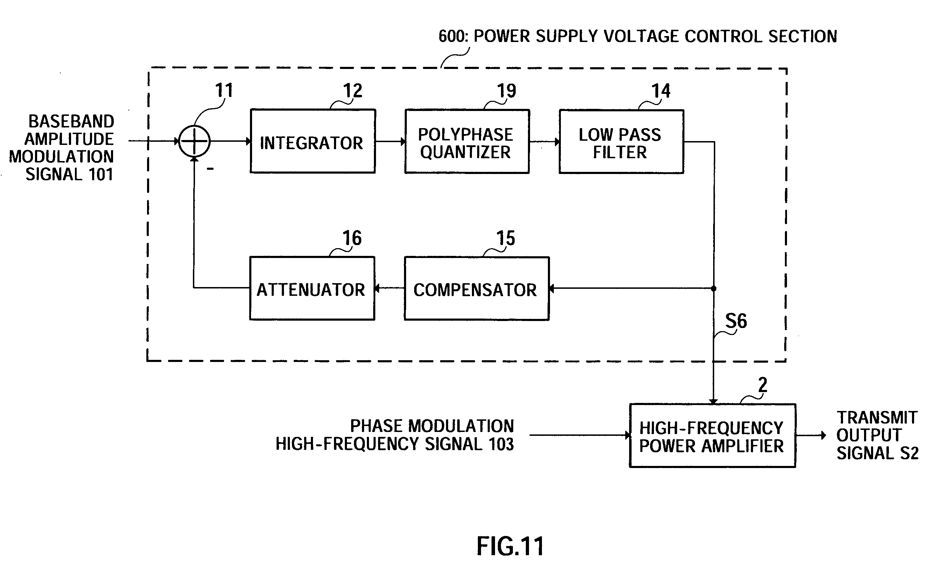

FIG. 11, in which parts corresponding to those in FIG. 7 are assigned the same codes as in FIG.7, shows the configuration of a power supply voltage control section according to a fifth embodiment of the present invention. Power supply voltage control section 600 of this embodiment basically has a delta sigma modulator configuration as in the first embodiment, but its configuration differs partially from that of the first embodiment.

Power supply voltage control section 600 is provided with a polyphase quantizer 19 as a quantizer.
The rest of the configuration is the same as in the first embodiment. As in the example shown in FIG.4, polyphase quantizer 19 is composed of N quantizers (1 through N) operating at a (1/N) sampling rate with respective (360/N) degree phase displacement, and quantizer outputs are combined by a combiner 128 and output in (N+1) value form.

According to the fifth embodiment, by using polyphase quantizer 19 instead of quantizer 13 of the first embodiment, in addition to obtaining the effects of the first embodiment, the reduction in the speed of each quantizer enables required quantizer conditions to be relaxed, thereby making it possible to perform wider-range amplitude modulation through widening of the signal band and so forth.

### (Sixth Embodiment)

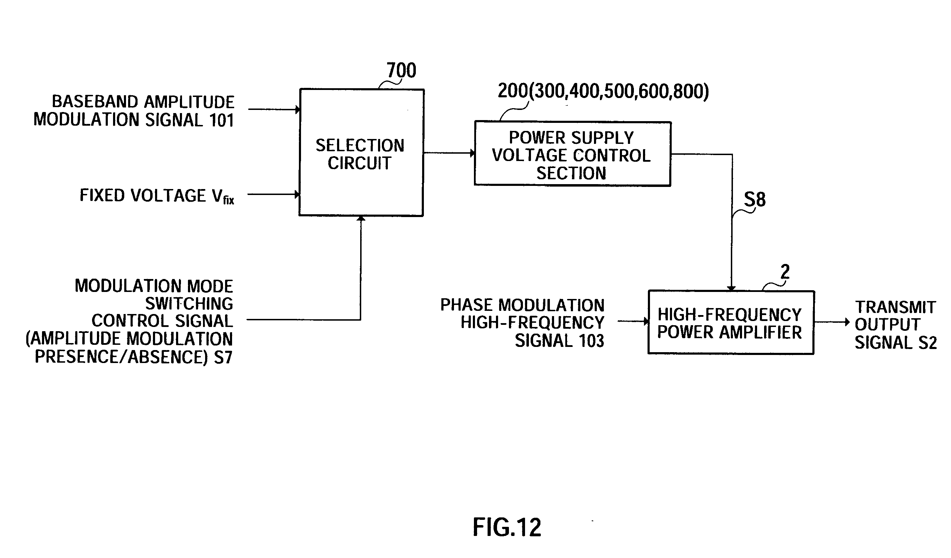

FIG.12, in which parts corresponding to those in FIG.7 are assigned the same codes as in FIG.7, shows the configuration of an amplification apparatus according to a sixth embodiment of the present invention.

An amplification apparatus of the sixth embodiment is provided with a selection circuit 700 corresponding to one example of an input selection section. Selection circuit 700 selects either baseband amplitude modulation signal 101 or a fixed voltage Vfix as the input signal of power supply voltage control section 200 with a delta sigma modulator configuration (the configuration shown in any of the first through fifth embodiments, or the eighth embodiment described later herein, may be used for the power supply voltage control section). Selection circuit 700 switches the input signal of power supply voltage control section 200 by means of a modulation mode switching control signal S7 that specifies the presence or absence of amplitude modulation in the modulation method used.

In this sixth embodiment, when implementation of a transmit modulator capable of handling a plurality of modulation methods is attempted, for a modulation method in which there is no amplitude modulation component (such as the GSM method), the selection circuit 700 input selection is switched by means of modulation mode switching control signal S7 and fixed voltage Vfix is input to power supply voltage control section 200, as a result of which power supply voltage control section 200 is operated as a DC-DC converter. That is to say, when the input baseband signal contains only a phase modulation component, power supply voltage control section 200 is operated as a DC-DC converter, and when the baseband signal contains a phase modulation component and amplitude modulation component, power supply voltage control section 200 is operated as a class D amplifier.

According to the sixth embodiment, by switching between input of a baseband amplitude modulation signal or input of a fixed voltage to a power supply voltage control section with a delta sigma modulator configuration according to the modulation method, the power supply voltage control section can be switched between operation as an ordinary class D amplifier and operation as a DC-DC converter. By this means, it is also possible to make the power supply voltage of high-frequency power amplifier 2 a fixed voltage, making it possible to handle modulation methods in which there is no amplitude modulation component, for example, and enabling various kinds of modulation methods to be supported. Thus, with this embodiment it is possible to form a delta sigma modulation signal S8 comprising a DC component in the power supply voltage control section, enabling the power supply voltage control section to be used in common for a plurality of modulation methods, and even for a modulation method in which there is no amplitude modulation component (such as the GSM method), for example.

### (Seventh Embodiment)

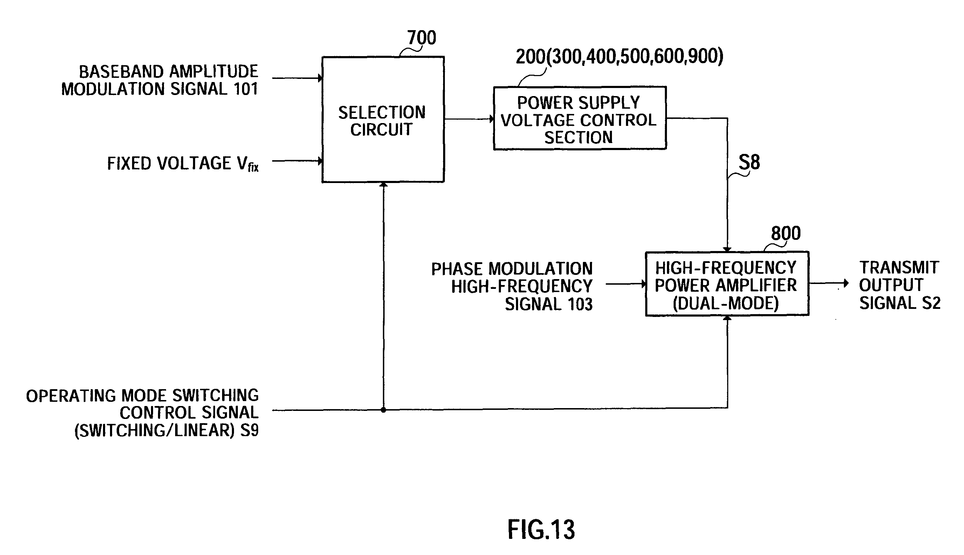

FIG.13, in which parts corresponding to those in FIG.7 are assigned the same codes as in FIG.7, shows the configuration of an amplification apparatus according to a seventh embodiment of the present invention.

An amplification apparatus of the seventh embodiment is provided with selection circuit 700 and also has a dual-mode type high-frequency power amplifier 800 that has two operating modes. Selection circuit 700 switches the input signal of power supply voltage control section 200 by means of an operating mode switching control signal S9 that specifies the operating mode. Also, high-frequency power amplifier 800 is switched to a switching operation or linear operation operating mode by means of operating mode switching control signal S9. By means of this configuration, switching control can be performed by means of operating mode switching control signal S9 to select switching operation or linear operation for high-frequency power amplifier 800.

In this seventh embodiment, if amplitude modulation of phase modulation high-frequency signal 103 must be performed in a stage prior to high-frequency power amplifier 800, a fixed-voltage delta sigma modulation signal S8 is sent to high-frequency power amplifier 800 by switching selection circuit 700 input selection by means of operating mode switching control signal S9 and inputting fixed voltage Vfix to power supply voltage control section 200. The operating mode of high-frequency power amplifier 800 is then switched from switching operation to linear operation and high-frequency power amplifier 800 is operated as a linear amplifier. That is to say, when power supply voltage control section 200 is operated as a DC-DC converter, high-frequency power amplifier 800 is operated in linear mode, and when power supply voltage control section 200 is operated as a class D amplifier, high-frequency power amplifier 800 is operated in switching mode.

According to the seventh embodiment, by switching between input of a baseband amplitude modulation signal and input of a fixed voltage to a power supply voltage control section with a delta sigma modulator configuration in line with the mode of a dual-mode type high-frequency power amplifier, it is possible to perform power supply voltage control appropriate to the mode of the high-frequency power amplifier, whether switching mode or linear mode. As a result, it is also possible to handle a case in which amplitude modulation of phase modulation high-frequency signal 103 is performed in a stage prior to the high-frequency power amplifier.

### (Eighth Embodiment)

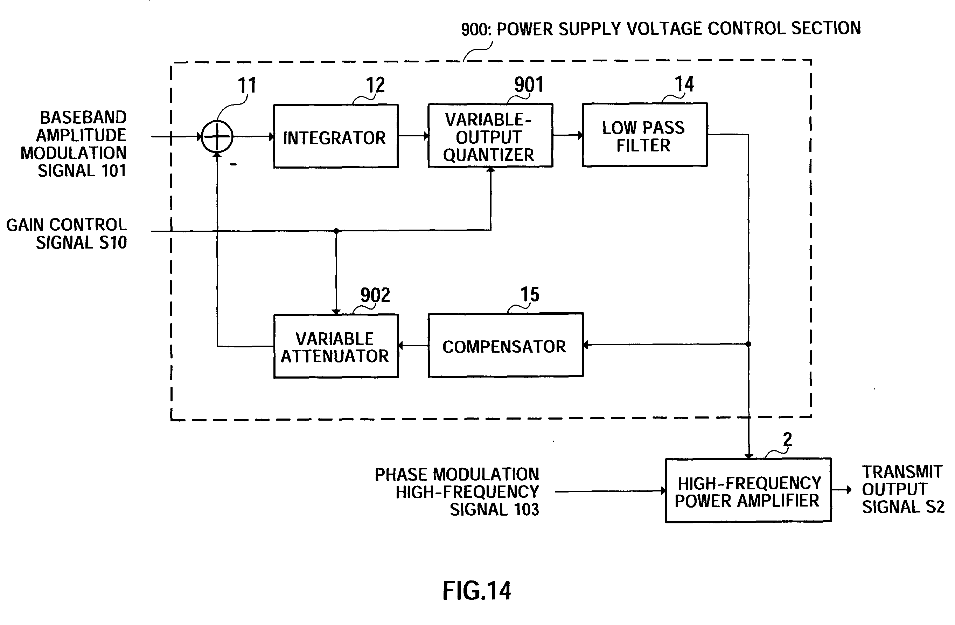

FIG.14, in which parts corresponding to those in FIG.7 are assigned the same codes as in FIG.7, shows the configuration of a power supply voltage control section according to an eighth embodiment of the present invention.

Power supply voltage control section 900 of the eighth embodiment has a variable-output quantizer 901 as a quantizer, and also has a variable attenuator 902 as an attenuator. The rest of the configuration is the same as in the first embodiment.

Variable-output quantizer 901 varies its output level in accordance with a gain control signal S10 that specifies the gain of high-frequency power amplifier 2. Variable attenuator 902 varies its attenuation factor in accordance with gain control signal S10 so that the loop gain of the delta sigma modulation negative feedback loop is constant. That is to say, the attenuation factor of variable attenuator 902 is set so that the product of the output level of variable-output quantizer 901 and the attenuation factor of variable attenuator 902 is constant, based on gain control signal S10.

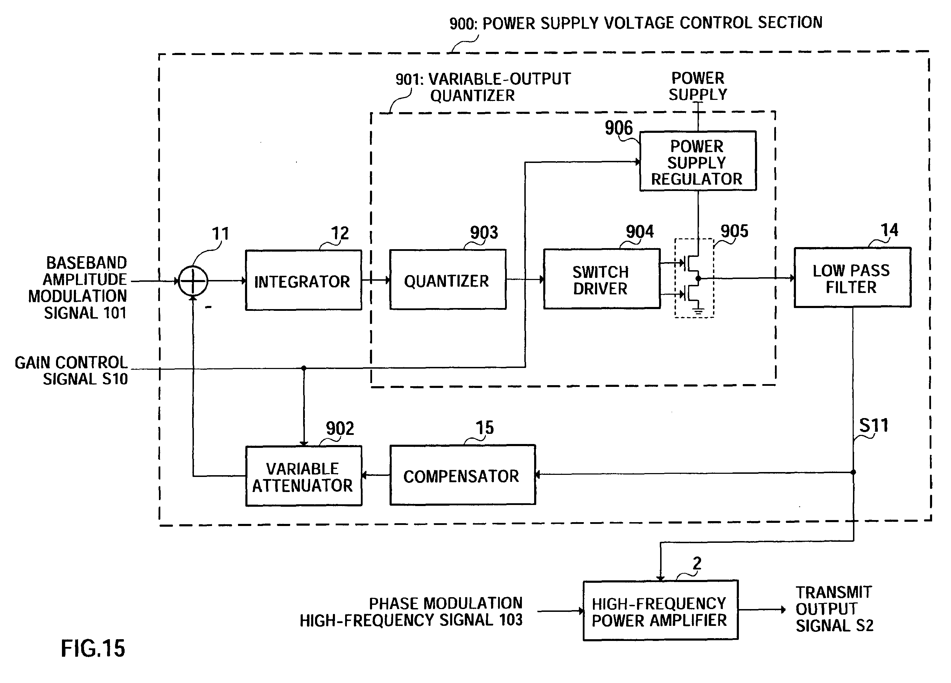

A sample configuration of variable-output quantizer 901 is shown in FIG.15.

Parts in FIG.15 identical to those in FIG.14 are assigned the same codes as in FIG.14. Variable-output quantizer 901 in FIG.15 is composed of a quantizer 903, a switch driver 904, an output transistor switch 905, and a power supply regulator 906. Power supply regulator 906 varies the power supply voltage of output transistor switch 905 in accordance with gain control signal S10. By this means, the signal level of delta sigma modulation signal S11 from power supply voltage control section 900 is changed by variation of the maximum output voltage of output transistor switch 905. Generally, when baseband amplitude modulation signal 101 itself is varied according to gain and the output level of a power supply voltage control section with a delta sigma modulator configuration is varied in the same way, the modulated signal level falls with respect to quantization noise due to delta sigma modulation, and therefore the S/N ratio falls. In contrast, when the signal level of delta sigma modulation signal S11 is varied by variable-output quantizer 901, as in this embodiment, quantization noise and the modulated signal both change, and therefore a decrease in the S/N ratio can be suppressed in comparison with the former case.

According to the eighth embodiment, by providing variable-output quantizer 901 that varies the signal level of a delta sigma modulation signal output from power supply voltage control section 900, and changing the signal level of the delta sigma modulation signal with the quantizer output, it is possible to suppress a decrease in the S/N ratio and also extend the dynamic range of delta sigma modulation signal S11.

As described above, according to these embodiments, by using a delta sigma modulator configuration for a power supply voltage control section that forms a control signal for controlling the power supply voltage of a high-frequency amplifier, distortion can be reduced by means of a delta sigma modulation negative feedback loop. In addition, since a delta sigma modulation configuration with a single-loop negative feedback circuit is used for the power supply voltage control section, it is possible to implement a high-efficiency amplification apparatus that enables high-frequency power amplification to be performed stably by a high-frequency power amplifier.

Also, since a power supply voltage control section according to these embodiments can also form a delta sigma modulation signal comprising a DC component, when implementation of an amplification apparatus capable of handling a plurality of modulation methods is attempted, the power supply voltage control section can also be used for a modulation method in which there is no amplitude modulation component (such as the GSM method). Thus, various kinds of modulation methods can be supported. Furthermore, when amplitude modulation must be performed in a stage prior to the high-frequency power amplifier, it is possible to switch the high-frequency power amplifier from switching operation to linear operation and also make the power supply voltage of the high-frequency power amplifier a fixed voltage, and amplitude modulation prior to power amplification can also be handled.

In the above embodiments, a case has been described in which an amplification apparatus according to the present invention is applied to a polar modulation type transmitter, but the present invention is not limited to this, and can be widely applied to amplification apparatuses that have a nonlinear high-frequency power amplifier that amplifies a first input signal, and a power supply voltage control section that forms a control signal for controlling the power supply voltage of the high-frequency amplifier based on a second input signal, and in which the signal level of the first input signal is amplified by the high-frequency power amplifier to a level in accordance with the second input signal.

The present invention is not limited to the above-described embodiments, and various variations and modifications may be possible without departing from the scope of the present invention.

According to one aspect of an amplification apparatus of the present invention, in an amplification apparatus that has a nonlinear high-frequency power amplifier that amplifies a first input signal, and a power supply voltage control section that forms a control signal for controlling the power supply voltage of the high-frequency amplifier based on a second input signal, and in which the signal level of the first input signal is amplified by the high-frequency power amplifier to a level in accordance with the second input signal, the power supply voltage control section has a configuration comprising an adder that adds together the second input signal and a negative feedback signal, an integrator that integrates the output of the adder, a quantizer that quantizes the output of the integrator in accordance with a predetermined threshold value, a low pass filter that eliminates quantization noise from the output of the quantizer, and a compensator that has an inverse characteristic of the low pass filter or a characteristic approximating thereto and performs compensation of the feedback amount of a negative feedback signal.

According to this configuration, the power supply voltage control section can be configured by means of a single negative feedback loop, enabling delta sigma modulation of the second input signal to be performed stably and also enabling distortion created by the low pass filter to be improved by the delta sigma modulation negative feedback loop. By this means, it is possible for amplification by the high-frequency power amplifier to be performed stably, and for output distortion to be reduced.

According to another aspect of the present invention, the aforementioned compensator is provided within a negative feedback loop from the aforementioned low pass filter toward the aforementioned adder, and performs compensation and feedback of part of the output of the aforementioned low pass filter.

According to this configuration, in the power supply voltage control section there is a negative feedback loop that performs feedback from the output of the low pass filter, and low pass filter output is input to a compensator that has an inverse characteristic of this low pass filter or a characteristic approximating thereto and performs compensation of the feedback amount of the negative feedback signal, making it possible to configure the power supply voltage section by means of a single negative feedback loop. By this means, it is possible for delta sigma modulation of the second input signal to be performed stably, and for operation of the high-frequency power amplifier to be stabilized.

According to another aspect of the present invention, the aforementioned compensator is provided within the main loop from the aforementioned adder toward the aforementioned low pass filter, and performs compensation of part of the output of the aforementioned adder.

According to this configuration, since the compensator is located in the main loop rather than the negative feedback loop in the power supply voltage control section, the circuit scale of the negative feedback loop can be reduced, whereby circuit oscillation and so forth can be prevented, and it is possible for delta sigma modulation of the second input signal to be performed stably and operation of the high-frequency power amplifier to be stabilized.

According to another aspect of the present invention, the aforementioned quantizer is configured as a polyphase quantizer having a plurality of quantizers. According to this configuration, since a polyphase quantizer having a plurality of quantizers is used as the quantizer in the power supply voltage control section, it is possible to relax the required quantizer conditions, enabling quantizer speed to be reduced, for example, and to perform wider-range delta sigma modulation.

According to another aspect of the present invention, the aforementioned power supply voltage control section is further provided with an input selection section that selectively inputs either the aforementioned second input signal or a fixed voltage, and the operation of the aforementioned power supply voltage control section is switched between operation as a class D amplifier and operation as a DC-DC converter in accordance with the input switching of the aforementioned input selection section.

According to this configuration, for example, by selecting a fixed voltage by means of the input selection section and inputting a fixed voltage to the power supply voltage control section, the power supply voltage control section can be operated as a DC-DC converter, and a fixed voltage can be supplied to the high-frequency power amplifier via the power supply voltage control section. Thus, for example, when handling a signal of a modulation method in which there is no amplitude modulation component, a fixed voltage can be supplied to the high-frequency power amplifier as a power supply, making it possible to support various kinds of modulation methods. Also, in this case, a power supply voltage control section that performs delta sigma modulation can be used in common for a plurality of modulation methods. According to another aspect of the present invention, the aforementioned high-frequency power amplification section is configured so as to have a switching operation mode and a linear operation mode, and the high-frequency power amplification section is switched to linear operation mode when the power supply voltage control section operates as a DC-DC converter. According to this configuration, for example, by inputting a fixed voltage to the power supply voltage control section and operating the power supply voltage control section as a DC-DC converter, it is possible to input a fixed voltage to the high-frequency power amplifier as a power supply, and to operate the high-frequency power amplifier in linear mode. By this means, it is possible to handle a case in which amplitude modulation is performed in a stage prior to the high-frequency power amplifier, and to perform linear amplification by the high-frequency power amplifier of a signal on which amplitude modulation is performed in a prior stage.

According to another aspect of the present invention, the aforementioned power supply voltage control section is further provided with an AD converter that converts analog output of the aforementioned low pass filter to a digital signal, compensation and feedback of part of the output of the aforementionedAD converter is performed by the aforementioned compensator, and the aforementioned adder, the aforementioned integrator, the aforementioned quantizer, and the aforementioned compensator are configured as digital circuits.

According to this configuration, digitalizion of the power supply voltage control section reduces susceptibility to the effects of element variation and the like, as a result of which the delta sigma modulation characteristic can be kept constant, and apparatus operating characteristics can be made uniform.

According to still another aspect of the present invention, the aforementioned power supply voltage control section comprises a variable attenuator that has an attenuation factor varying function in the negative feedback loop from the aforementioned low pass filter toward the aforementioned adder, and the aforementioned quantizer is configured as a variable-output quantizer that has an output level varying function, and operates so that the product of the output level of the aforementioned variable-output quantizer and the attenuation factor of the aforementioned variable attenuator is constant.

According to this configuration, the output of the power supply voltage control section can be changed with the output of the quantizer, making it possible to suppress a decrease in the S/N ratio, and also to extend the dynamic range of the control signal output from the power supply voltage control section, and thus of the output signal of the high-frequency power amplifier.

As described above, according to the present invention an amplification apparatus can be implemented that makes it possible to perform high-frequency power amplification stably and also reduce distortion of high-frequency power amplification output.

Also, an amplification apparatus can be implemented that makes it possible to provide a fixed voltage to a high-frequency power amplifier and handle various kinds of modulation methods.

This application is based on Japanese Patent Application No. 2003-280256 filed on July 25, 2003, Japanese Patent Application No. 2003-336801 filed on September 29, 2003, and Japanese Patent Application No.2004-48341 filed on February 24, 2004, the entire content of which is expressly incorporated by reference herein.

### Industrial Applicability

An amplification apparatus of the present invention is suitable for application to a polar modulation type radio transmitter or the like, for example.

## Claims

1. An amplification apparatus that has a nonlinear high-frequency power amplifier that amplifies a first input signal; and a power supply voltage control section that forms a control signal for controlling a power supply voltage of said high-frequency amplifier based on a second input signal; and that amplifies a signal level of said first input signal by means of said high-frequency power amplifier to a level in accordance with said second input signal,
wherein said power supply voltage control section comprises:
an adder that adds together said second input signal and a negative feedback signal;
an integrator that integrates output of said adder;
a quantizer that quantizes output of said integrator in accordance with a predetermined threshold value; a low pass filter that eliminates quantization noise from output of said quantizer; and
a compensator that has an inverse characteristic of said low pass filter or a characteristic approximating thereto and performs compensation of a feedback amount of said negative feedback signal.

2. The amplification apparatus according to claim 1, wherein said compensator is provided within a negative feedback loop from said low pass filter toward said adder, and performs compensation and feedback of part of output of said low pass filter.

3. The amplification apparatus according to claim 1, wherein said compensator is provided within a main loop from said adder toward said low pass filter, and performs compensation of part of output of said adder.

4. The amplification apparatus according to claim 1, wherein:
said powersupply voltage control section further comprises a detector that extracts said second input signal component from output of said high-frequency power amplification section; and
said compensator performs compensation and feedback of part of output of said detector.

5. The amplification apparatus according to claim 1, wherein said quantizer is configured as a polyphase quantizer having a plurality of quantizers.

6. The amplification apparatus according to claim 1, wherein: said power supply voltage control section further comprises an input selection section that selectively inputs either said second input signal or a fixed voltage; and
operation of said power supply voltage control section is switched between operation as a class D amplifier and operation as a DC-DC converter in accordance with input switching of said input selection section.

7. The amplification apparatus according to claim 6, wherein said high-frequency power amplification section has a switching operation mode and a linear operation mode, and executes linear operation mode when said power supply voltage control section operates as a DC-DC converter.

8. The amplification apparatus according to claim 1, wherein:
said power supply voltage control section further comprises an AD converter that converts analog output of said low pass filter to a digital signal;
said compensator performs compensation and feedback of part of output of said AD converter; and
said adder, said integrator, said quantizer, and said compensator are configured as digital circuits.

9. The amplification apparatus according to claim 1, wherein:
said power supply voltage control section comprises a variable attenuator that has an attenuation factor varying function in a negative feedback loop from said low pass filter toward said adder; and
said quantizer is configured as a variable-output quantizer that has an output level varying function, and operates so that a product of an output level of said variable-output quantizer and an attenuation factor of said variable attenuator is constant.

10. The amplification apparatus according to claim 9, wherein said variable-output quantizer comprises an output transistor switch and a power supply regulator, and varies a power supply voltage of said output transistor switch by means of said power supply regulator.

11. The amplification apparatus according to claim 1, wherein: said amplification apparatus is provided in a polar modulation transmitter; said first information signal is a phase modulation high-frequency signal in which a carrier frequency is modulated by a phase modulation signal of a baseband modulation signal; and said second input signal is an amplitude modulation signal of said baseband modulation signal.
